# EUROPÄISCHE PATENTSCHRIFT

(11) **EP 0 670 081 B1**
(45) Veröffentlichungstag und Bekanntmachung des Hinweises auf die Patenterteilung: **04.03.1998**
(21) Anmeldenummer: 94900139.0
(22) Anmeldetag: 12.11.1993
(51) Int. Cl.: H01R 9/05, H01R 9/09, H01R 17/12

(54) **KOAXIALE HOCHFREQUENZ-STECKVERBINDUNG FÜR DEN ANSCHLUSS ZAHLREICHER KOAXIALLEITUNGEN**
COAXIAL HIGH-FREQUENCY PLUG-TYPE CONNECTOR FOR MULTIPLE COAXIAL LINES
CONNECTEUR COAXIAL A FICHES POUR LA CONNEXION D'UNE PLURALITE DE LIGNES COAXIALES

(30) Priorität: 17.11.1992 DE 4238747
(43) Veröffentlichungstag der Anmeldung: 06.09.1995
(73) Patentinhaber: GORE ENTERPRISE HOLDINGS, INC., Newark, DE 19714-9329 (US)
(72) Erfinder: CRAMER, Ralf, D-70190 Stuttgart (DE); EMMERICH, Herbert, D-71334 Waiblingen-Neustadt (DE)
(74) Vertreter: Klunker . Schmitt-Nilson . Hirsch
(86) Internationale Anmeldenummer: EP9303177
(87) Internationale Veröffentlichungsnummer: WO9411924

(56) Entgegenhaltungen:
- GB-A- 827 209
- US-A- 3 214 827
- US-A- 4 679 321
- US-A- 5 123 164

## Beschreibung

Die Erfindung betrifft eine Anordnung für eine koaxiale Hochfrequenz Steckverbindung für den Anschluß mehrerer Koaxialleitungen, in der die Steckeranschlüsse für Koaxialleitungen unmittelbar benachbart in einer Reihe angeordnet sind und von einem gemeinsamen Gehäuse umschlossen werden, mit den Merkmalen gemäß Oberbegriff des Patentanspruchs 1.

Koaxiale Hochfrequenz-Steckverbindungen für Hochfrequenztechnik sind an sich bekannt. Koaxialsteckverbindungen für den Anschluß zahlreicher Koaxialleitungen werden beispielsweise in der Übertragungstechnik benötigt. Dort werden Signalgeschwindigkeiten für Koaxialleitungen im HF-Bereich mit bis zu 93 Prozent der Lichtgeschwindigkeit erreicht. Angesichts der heutigen ständig fortschreitenden Miniaturisierung von Bauteilen, wie z.B. von integrierten Schaltkreisen, die eine immer größere Packungsdichte von Funktionen auf dem gleichen Raum beinhalten, entsteht der Zwang, eine immer größere Anzahl von Anschlüssen zur Übermittlung der Signale der Bauteile auf kleinerem Raum unterzubringen. Für den geschilderten Fall der Koaxialleitungen bedeutet dies, daß immer mehr Koaxialleitungen auf möglichst kleinem Raum parallel nebeneinander an Stecker herangeführt werden müssen. Bisher wurden bei direkt nebeneinanderliegenden Koaxialleitungen ein unterer Rasterabstand für die einzelnen Leitungen von 2,54 mm bei den Steckverbindungen erreicht. Die bisherigen Steckeranschlüsse für Signal und Masse werden mit den Signal- und Masseleitungen der Koaxialleitungen manuell per Löttechnik verbunden und sind deshalb auch nicht so gestaltet, daß ein automatisches und maschinelles Anschließen dieser Leitungen möglich ist. Durch die eng nebeneinanderliegenden Signal- und Massedrähte kommt es durch den Lötvorgang leicht zu Kurzschlüssen und damit zu Fehlern im Steckeraufbau. Nach dem Stand der Technik werden die Signal- und Masseleitungen der nebeneinander angeordneten Koaxialleitungen auf die jeweiligen Signal- und Massekontakte des Steckers lediglich aufgelegt. Dieses Verfahren führt zu zusätzlichen weiteren Fehlern beim elektrischen Anschluß der Leitungen der Koaxialleitungen mit den Kontaktstellen des Steckers. So kommt es beispielsweise bei Hochfrequenzleitungen, deren Signal- und Masseleitungen aus dünnen Drähten oder Litzen bestehen, die jeweils federnde Eigenschaften aufweisen, beim Auflegen der Signal- und Masseleitungen der Koaxialleitungen auf die Kontaktstellen einmal immer wieder zu einem nicht einwandfreien Berühren der Enden der Signalleitungen und der Masseleitungen der Koaxialleitungen mit den Kontaktstellen der Steckverbindung, sodaß beim Lötvorgang kein Kontakt zwischen den beiden zu verbindenden Teilen entsteht. Andererseits kommt es durch das elastische Verhalten des dünnen Drahtes mit seiner dielektrischen Isolierung oder auch bei den federnden Litzen zu Kurzschüssen zwischen den eng nebeneinanderliegenden Kontaktstellen der Steckverbindungen. Derartige Fehlerquellen müssen durch eine entsprechende visuelle Kontrolle und durch einen zeitaufwendigen Reparaturvorgang beseitigt werden. Schwierigkeiten bei der Positionierung der Signal- und Masseanschlüsse der Koaxialleitungen bei ihren ungemein eng nebeneinander zu liegenkommenden Anschlüssen auf der Steckverbindung bereitet auch die Tatsache, daß bei derartig geringen Abständen praktisch keine Greifer zum Halten der einzelnen Leitungen eingesetzt werden können.

Aus dem deutschen Gebrauchsmuster Nr. 1 939 167 ist eine Steckverbindungsvorrichtung für den Steckverbindungsanschluß mehrerer Koaxialkabel bekannt. Dabei sind auf einer isolierenden Trägerplatte in einer Reihe mehrere Koaxialkabelbuchsen angeordnet. Jede dieser Buchsen ist an der Trägerplatte mittels einer Schraubverbindung befestigt. Jede Buchse weist eine Lötfahne zur Lötverbindung mit einem Masseleiter auf.

Aus Funk-Technik 36 (1981), Heft 10, Seite 374, ist es bekannt, Koaxialkabel unter Zwischenschaltung eines metallischen Koaxialübergangs elektrisch mit Leiterplatinen zu verbinden. Der Koaxialübergang weist die Form einer Metallhülse auf, die auf den freigelegten Schirmleiter des Koaxialkabels aufgebracht wird und mindestens einen durch eine Öffnung der Leiterplatte hindurchsteckbaren Masseanschlußstift und eine Durchtrittsöffnung für den isolierten Innenleiter des Koaxialkabels aufweist. Ein freigelegtes Ende des Innenleiters wird durch eine weitere Öffnung der Leiterplatine hindurchgesteckt. Der Masseanschlußstift und der Innenleiter des Koaxialkabels werden je auf der vom Koaxialkabel abliegenden Seite der Leiterplatine mit Leiterbahnen der Leiterplatine verlötet.

Aus der GB 2 104 312 A ist ein Koaxialkabelverbinder bekannt, der einen Buchsenkontakt, einen den Buchsenkontakt aufnehmenden Isolierkörper und ein den Isolierkörper umgebendes metallisches Gehäuse aufweist. Der Buchsenkontakt weist einen Leiteranschlußbereich auf, mit welchem der Innenleiter des Koaxialkabels verbunden wird. Das Metallgehäuse besitzt an dem zum Koaxialkabel weisenden Ende einen zylindrischen Fortsatz verringerten Durchmessers, der zwischen das den Innenleiter umgebende Dielektrikum und den Schirmleiter des Koaxialkabels geschoben wird, wonach auf den über den Fortsatz geschobenen, von einem Kabelmantel befreiten Bereich des Schirmleiters ein Crimpring aufgequetscht wird.

Aus der DE 19 16 502 A ist ein mit einem Koaxialkabel verbundener Koaxialsteckverbinder bekannt, bei welchem ein Steckeraußenleiter mit einer Aufnahmekammer für einen Steckerinnenleiter und eine den Steckerinnenleiter umgebende Steckerisolation vorgesehen sind. Der Steckeraußenleiter ist mit einer Einführöffnung versehen, durch welche hindurch ein freigelegtes Ende des Koaxialkabelinnenleiters in eine Aufnahmeöffnung des in der Kammer befindlichen Steckerinnenleiters gebracht werden kann. Im Bereich der Einführöffnung des Steckeraußenleiters ist der Koaxialkabelinnenleiter noch mit seinem Dielektrikum versehen, nicht jedoch mit dem Außenleiter oder Schirmleiter. Der Kabelaußenleiter ist vor dem Hindurchführen des Kabelinnenleiters durch die Einführöffnung trompetenförmig aufgeweitet worden, so daß er beim Vorgang des Einführens des Kabelinnenleiters in die Aufnahmeöffnung des Steckerinnenleiters in Anlage an eine die Einführöffnung umgebende Radialwand des Steckeraußenleiters gelangt.

Aus dem Dokument US-A-4,679,321 sind mit als Koaxialkabel ausgeführten Brücken versehene Leiterplatinen sowie ein entsprechendes Herstellungs-Verfahren dafür bekannt. Die Leiterplatinen sind beidseitig mit elektrischen Leiterbahnen versehen. Die Koaxialkabel werden angeschlossen, indem zunächst die Leiterplatine mit einer Durchgangsbohrung versehen wird. Danach wird die abgemantelte Koaxialleitung durch die Bohrung gesteckt und der Signalleiter abgebogen und mit einer Leiterbahn auf der Platinenunterseite verbunden. Der Schirm des Koaxialkabels wird mit einer Leiterbahn auf der Platinenoberseite verbunden.

Der Erfindung liegt die Aufgabe zugrunde, eine Anordnung zur Verbindung von mehreren Koaxialleitungen verfügbar zu machen, die für eine Massenfertigung von hochfrequenztauglichen Koaxial-Steckverbindern geeignet ist und insbesondere ein automatisches und maschinelles Anschließen von mehreren Koaxialleitungen gleichzeitig gestattet, dabei das Erreichen engster Rasterabstände für den Anschluß der Koaxialleitungen an den Steckverbinder ermöglicht und eine hohe Positioniergenauigkeit und Prozeßsicherheit für das Herstellen der elektrischen Verbindungen zwischen den Signalleitungen und Masseleitungen der Koaxialleitungen und den entsprechenden Signalkontakten und Massekontakten des Koaxialsteckverbinders erzielen läßt.

Eine Lösung dieser Aufgabe besteht in einer Anordnung gemäß Anspruch 1, die gemäß den Ansprüchen 2 bis 8 vorteilhaft weitergebildet werden kann. Mit einer derartigen Anordnung aufgebaute Steckverbinder sind in den Ansprüchen 9 und 10 angegeben.

Es werden nun Vorteile der Erfindung und erfindungsgemäßer Ausführungsformen betrachtet.

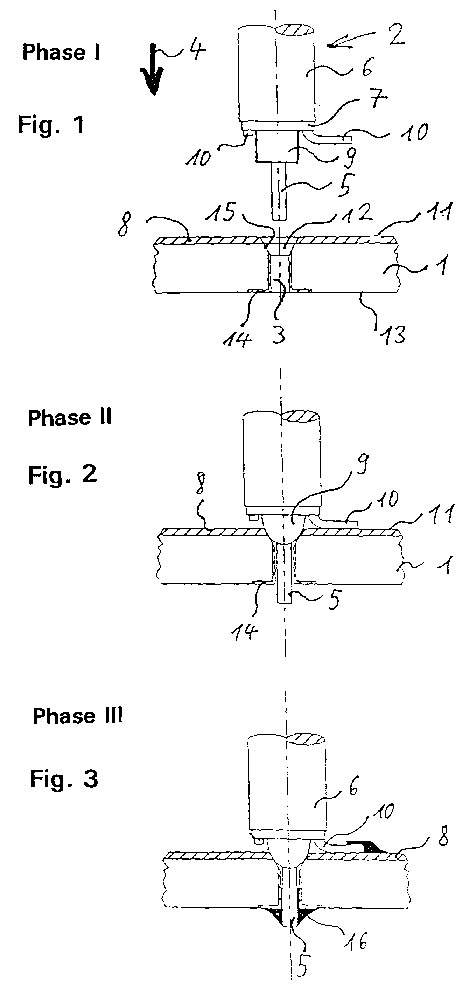

Vorteilhaft bei der Ausführungsform nach Fig. 2, die mit einer Leiterplatine aufgebaut ist, ist insbesondere, daß über die Leiterplatine eine Trennung der elektrischen Anschlüsse der Signalleitungen und der Masseleitungen der einzelnen Koaxialleitungen in zwei elektrisch voneinander isolierte Ebenen erfolgt. Dazu ist die Leiterplatine beidseitig mit Leiterbahnen versehen, wobei für die Signalleitungen der Koaxialleitungen Durchgangslöcher im Abstand der Rastermaßes durch die Leiterplatine vorgesehen sind. Jedem einzelnen der Durchgangslöcher ist für die jeweilige Signalleitung eine Einlaufphase in Form einer trichterförmigen Erweiterung vorgelagert. Da zahlreiche Koaxialleitungen parallel nebeneinander liegend eingeklemmt auf einem Werkstückträger gemeinsam der Leiterplatine zugeführt werden, kann trotz der aus dünnen Drähten bestehenden Signalleitungen, die dadurch elastisch und federnd und teilweise verbogen sind, ein einwandfreies automatisches und schnelles Anschließen dieser Signalleitungen auf der Leiterplatine erfolgen. Dies wird dadurch gewährleistet, daß die trichterförmige Erweiterung der Einlaufphase einen Toleranzbereich für die Positioniergenauigkeit der Signalleiter schafft und beim Annähern und Einführen der Mittelleiter in die Leiterplatine alle Mittelleiter trotzdem zwangsgeführt in die Durchgangslöcher der Leiterplatine gesteckt werden. Bei der automatischen Verarbeitung mittels eines Handhabungsgerätes erfolgt durch die Einlaufphase in Form einer trichterförmigen Erweiterung ein passiver Toleranzausgleich, der wiederum auch Positionierungsungenauigkeiten noch ausgleichen kann und damit auch die Prozeßsicherheit für das Herstellen einer elektrischen Verbindung zwischen den jeweiligen Signalleitern der Koaxialleitungen und den elektrischen Leiterbahnen auf der Leiterplatine einwandfrei durch Löten oder andere Verbindungstechniken ermöglicht.

Die in Anspruch 2 angegebene Ausführungsform der Erfindung ermöglicht auch den automatisierten und maschinellen Anschluß der zusammengefaßten Masseabschirmdrähte oder von Massebeidrähten für jede der nebeneinanderliegenden Koaxialleitungen gleichzeitig . Zu diesem Zweck ist auf der Leiterplatine eine gemeinsame Masseanschlußbahn für alle Masseleitungen der Koaxialleitungen vorgesehen. Diese gemeinsame Masseanschlußbahn ist auf der Leiterplatine auf der den zugeführten Koaxialleitungen zugewandten Seite angeordnet. Durch winkliges Abbiegen aller Masseleitungen der Koaxialleitungen im Winkel von 90 Grad liegen alle Masseleitungen der einzelnen Koaxialleitungen nach dem gemeinsamen Zuführen mittels des Werkstückträgers gleichzeitig auf der gemeinsamen Massebahn der Leiterplatine auf und können damit in einer für die Massenfertigung geeigneten Weise elektrisch und maschinell verbunden werden. Die Durchgangslöcher durch die Leiterplatine für die Signalleitungen der einzelnen Koaxialleitungen lassen sich außerordentlich eng nebeneinander anordnen. Dadurch läßt sich der Rasterabstand zwischen den einzelnen zugeführten Koaxialleitungen so stark verkleinern, daß mindesten eine Halbierung des bisher im Stand der Technik möglichen Rasterabstandes ermöglicht wird. So läßt sich durch die Kombination der Merkmale dieser Ausführungsform, nämlich die Trennung der elektrischen Anschlüsse der Signalleitungen und der Masseleitungen der anzuschließenden Koaxialleitungen in zwei elektrisch voneinander isolierte Ebenen, die beiderseitig Anbringung von Leiterbahnen auf der Leiterplatine, das Vorsehen von Durchgangslöchern im Rastermaß mit einer Vorlagerung einer Einlaufphase in Form einer trichterförmigen Erweiterung, die Ausbildung der Wandfläche der trichterförmigen Enveiterung als elektrisch isolierend und das winkelige Abbiegen der Masseleitungen der anzuschließenden Koaxialleitungen, die genannte Aufgabe lösen und vorteilhaft eine Hochfrequenzsteckverbindungsvorrichtung verwirklichen.

Die Vorteile der im Anspruch 3 angegebenen Ausführungsform der Erfindung liegen insbesondere darin, daß ein gemeinsamer Zwischenträger für alle Basisgehäuse vorgesehen ist. Diese Basisgehäuse dienen zum Anschluß der zahlreichen einzelnen Koaxialleitungen an die Hochfrequenzsteckverbindungen. Der Zwischenträger ist dabei als geschlossener zeilenartig fortgeführter Block mit parallel nebeneinander liegenden Öffnungen ausgestattet, wobei diese Öffnungen die Basisgehäuse zum Anschluß der einzelnen Koaxialleitungen bilden. Die einzelnen Basisgehäuse sind also in dem Zwischenträger zu einem einzigen Block zusammengefaßt, der in dem Gesamtgehäuse verschiebbar gelagert ist. Dem Signalkontakt eines jeden Basisgehäuses ist neben einer ersten Öffnung zur Zuführung der Signalleitung eine zweite Öffnung zugeordnet, die den Zugang zur Kontaktstelle zwischen dem Signalkontakt des Basisgehäuses und der Signalleitung zum elektrischen Verbinden dieser beiden Teile gestattet. Die aus dünnen Drähten bestehenden Signalleitungen der Koaxialleitungen führen im Stand der Technik durch ihre Elastizität und durch ihre federnden Eigenschaften häufig zu Positionierfehlern an den Kontaktstellen. Damit ein automatisches und maschinelles Anschließen zahlreicher Signalleitungen nebeneinander unter Ausschaltung solcher Positionierfehler ermöglicht wird, sind bei dieser Ausführungsform der Erfindung in den Basisgehäusen jeweils zentrisch angeordnete Durchgangslöcher für die Signalleitungen vorgesehen, wobei jedem Durchgangsloch eine Einlaufphase in Form einer trichterförmigen Erweiterung des Durchgangsloches vorgelagert ist. Durch diese trichterförmige Erweiterung liegen sämtliche Signalleitungen im Toleranzbereich der Einlaufphase des jeweiligen Durchgangsloches. Durch die trichterförmige Erweiterung mit dem weiterführenden Durchgangsloch bildet sich stets eine Zwangsführung für die Signalleitungen. Diese Bohrung mit einer trichterförmigen Erweiterung ermöglicht es daher auch, federnde oder leicht elastische Signalleitungen an der Anschlußstelle richtig zu positionieren, wenn sie maschinell in die Einlaufphase des Basisgehäuses eingeschoben werden. Bei der automatischen Verarbeitung mittels eines Handhabungsgerätes erfolgt durch diese trichterförmige Erweiterung ein passiver Toleranzausgleich, der wiederum auch Positionierungsungenauigkeiten noch ausgleichen kann.

Die Ausführungsform nach Anspruch 3 ist auch mit Merkmalen versehen, um die zusammengefaßten Masseabschirmdrähte oder eventuelle Beidrähte der Abschirmung ebenfalls automatisiert und maschinell für jede der nebeneinander liegenden Koaxialleitungen gleichzeitig anschließen zu können. Dazu ist die koaxiale Hochfrequenzsteckverbindung für jede einzelne Masseleitung der zahlreichen Koaxialleitungen mit je einer verbiegbaren Lasche am Gesamtgehäuse pro Massekontakt ausgestattet. Die entsprechend vorgebogenen und zugeführten einzelnen Masseleitungen der Koaxialleitungen legen sich beim Einschieben des bereits mit allen Signalleitungen kontaktierten Zwischenträgers automatisch auf die entsprechend ausgebildeten Laschen der Gesamtgehäusewand. Da die zugeführten einzelnen Koaxialleitungen der koaxialen Hochfrequenzsteckverbindungen mit einer entsprechenden, hier nicht dargestellten Vorrichtung starr im vorgesehenen Rasterabstand geführt werden, legen sich die vorgebogenen Masseleitungen der einzelnen Koaxialleitungen exakt auf die entsprechend vorgebogenen Laschen der Gesamtgehäusewand und lassen sich nun durch geeignete Lötvorrichtungen elektrisch miteinander verbinden. Auch hier bei der zweiten Ausführungsform führt die Kombination der erfinderischen Merkmale, nämlich die Ausbildung des Zwischenträgers als ein geschlossener zeilenartig fortgeführter Block, in den die Basisgehäuse für die einzelnen Koaxialleitungen integriert sind, das Vorsehen einer ersten und einer zweiten Öffnung in dem Zwischenträger für jedes Basisgehäuse, das Verbiegen der Masseleitungen der Koaxialleitungen und das Vorsehen von Laschen am Gesamtgehäuse für die einzelnen Masseleitungen sowie das Verbiegen dieser Laschen entsprechend den Masseleitungen der Koaxialleitungen, dazu, daß die gesteiite Aufgabe gelöst werden kann. Die geschilderten ersten Öffnungen, die die Basisgehäuse bilden, können ganz eng unmittelbar nebeneinander angeordnet werden. Dadurch lassen sich bisher nicht mögliche enge Rasterabstände von Signalleitung zu Signalleitung der Koaxialleitungen erreichen. Die aus dem Stand der Technik bekannten Rasterabstände von 2,54 mm zwischen zwei Signalleitungen lassen sich wenigstens halbieren. Das zentrisch angeordnete Durchgangsloch mit der jeweils vorgelagert Einlaufphase in Form einer trichterförmigen Erweiterung für jedes Basisgehäuse sorgt für eine hohe Positioniergenauigkeit und die erforderliche Prozeßsicherheit, sodaß jeder elektrische Verbindungsvorgang durch Löten, Schweißen oder andere geeignete Verfahren, ohne Fehler zwischen den Signalkontakten der Hochfrequenzsteckverbindungen und dem Signalleiter der Koaxialleitungen und den entsprechenden Masseleitungen bzw. Masselaschen des Gesamtgehäuses, gelingt.

Nachstehend wird die Erfindung anhand von Ausführungsbeispielen von Zeichnungen noch mehr erläutert.

Es zeigen:
- Figur 1: eine erste Ausführungsform der Erfindung mit einer Leiterplatine im Querschnitt, wobei die Koaxialleitung noch nicht in die Platine eingeführt ist
- Figur 2: die Anordnung nach Figur 1 mit in die Leiterplatine eingeführter Koaxialleitung ;
- Figur 3: die Anordnung nach Figur 1 nach dem elektrischen Anschluß der Koaxialleitungen an die Leiterbahnen der Leiterplatine;
- Figur 4: eine zweite Ausführungsform der Erfindung mit einem Zwischenträger in Form eines geschlossenen zeilenartig fortgeführten Blocks; und
- Figur 5 - 8: Schnittdarstellungen verschiedener Phasen eines die Verbindungsvorganges zwischen den Signal- und Masseleitungen der Koaxialleitungen und den entsprechenden Anschlüssen eines Steckverbinders.

In den Figuren 1 - 3 ist der Gegenstand der ersten Ausführungsform der Erfindung nur in einer Prinzipskizze dargestellt. Es wird dort lediglich die Verbindung zwischen einer Leiterplatine 1 und Koaxialleitungen 2 für eine koaxiale Hochfrequenzsteckverbindung gezeigt. Die Leiterplatine 1 hat eine in den Figuren nicht dargestellte längliche Form und zwar entsprechend der Anzahl der dort zu befestigigenden Koaxialleitungen. Dazu sind im Abstand des Rastermaßes Durchgangslöcher 3 für die Signalleitungen der Koaxialleiter in die Leiterplatte nebeneinander liegend und in einer Reihe angeordnet eingebohrt. Nach Anschließen aller einzelnen Koaxialleitungen an die Leiterplatine führen die auf der Leiterplatine angebrachten Leiterbahnen die jeweiligen Signal- bzw. Masseleitungen zu den Steckern oder Buchsen des koaxialen Hochfrequenzsteckers, wobei diese Stecker und Buchsen in den Figuren 1 bis 3 nicht dargestellt sind. Die Leiterplatine 1 wird dabei von einem hier ebenfalls nicht dargestellten Gesamtgehäuse umgeben, das aus Metall ausgeführt ist, so daß eine Hochfrequenzabschirmungswirkung für die angeschlossenen koaxialen Leiter entsteht. Das Gesamtgehäuse der koaxialen Hochfrequenzsteckverbindung kann dabei je nach den Anforderungen als Buchsenstecker oder Stiftstecker ausgebildet sein. Die Stifte und Buchsen können dabei direkt auf der Leiterplatine 1 angebracht sein oder auch an dem Gesamtgehäuse selbst, während dann die Leiterplatine in entsprechende im Inneren des Steckverbinders angeordnete Anschlüsse der Buchsen und Stecker des Gesamtgehäuses gesteckt wird, was hier ebenfalls nicht dargestellt ist.

Der Übersichtlichkeit halber wurde der Anschluß zwischen einer Koaxialleitung 2 und der Leiterplatine 1 in stark vergrößertem Maßstab in den Figuren 1 bis 3 dargestellt. Die Leiterplatine 1 ist dabei quer zu ihrer Längsausdehnung geschnitten, in der sich die nebeneinander angeordneten Durchgangslöcher 3 im Rasterabstand auf einer Geraden angeordnet befinden, dabei ist nur ein kleiner Teil der Leiterplatine sowie eine von zahlreichen Koaxialleitungen dargestellt. Die Gesamtzahl der Koaxialleitungen 2 wird gleichzeitig in Zuführungsrichtung 4 senkrecht in die Durchgangslöcher 3 der Leiterplatine 1 eingeführt, siehe dazu Figur 2. Die Koaxialleitung 2 ist dabei von ihrem Mantel 6 entsprechend den konstruktiven Gegebenheiten abisoliert. Eine Abschirmung 7 des Koaxialkabels wird entweder zusammengedreht und als Masseleitung 10 herausgeführt oder es sind in dem dargestellten Beispiel in den Figuren 1 bis 3 in der Koaxialleitung zwei Massebeidrähte innerhalb der Abschirmung mitgeführt, die als Masseleitungen verwendet werden. Dabei ist ein Massebeidraht unmittelbar beim Austritt aus der Mantelisolierung 6 abgeschnitten. Diese Masseleitungen 10 der Koaxialleitungen werden winkelig von dem Dielektrikum 9 in Form beispielsweise eines Kunststoffschlauchs von der Signalleitung 5 abgebogen. Da die Zuführungsrichtung 4 der Koaxialleitungen 2 hier senkrecht auf der Leiterplatine 1 steht, ist der Abbiegewinkel für die Masseleitungen 10 der Koaxialleitungen 2 bevorzugt mit 90° gewählt. Dadurch liegen nach dem Einführen der Koaxialleitungen 2 alle Masseleitungen 10 der Koaxialleitungen planparallel auf dem Massekontakt 8 der Leiterplatine 1 der Steckverbindung auf. Dabei ist der Massekontakt 8 für alle Masseleitungen 10 der Koaxialleitungen 2 als gemeinsame Leiteroberfläche 11 für alle Masseanschlüsse 10 ausgeführt, da hier eine Potentialtrennung der einzelnen Masseanschlüsse nicht benötigt wird und auch nicht erwünscht ist. Das Dielektikum 9 in Form einer Isolierung der Signalleitungen 5 der Koaxialleitung 2 steht nach Abisolierung der Abschirmung um eine Länge vor, die der Tiefe einer Einlaufphase 12 entspricht, die dem Durchgangsloch 3 aus der Zuführungsrichtung 4 der Koaxialleitungen 2 gesehen, vorgelagert ist. Die Durchgangslöcher 3 auf der Platine 1 sind ursprünglich elektrisch leitend zur anderen Seite 13 der Platine durchkontaktiert, die die der Zuführungsrichtung 4 der Koaxialleitungen 2 abgewandte Seite der Platine bildet.

Durch geeignete konstruktive Maßnahmen, wie z.B. beim Herstellen der Einlaufphase 12 vor den Durchgangslöchern 3 durch Bohren, wobei jedoch auch jede andere geeignete Herstellung möglich ist, wird die Einlaufphase 12 in Form einer trichterförmigen Enveiterung hergestellt. Dabei wird sowohl die Leiteroberfläche 11 bzw. ein Teil der Massekontakte 8 wie auch ein Teil der in die Durchgangslöcher 3 hineinreichenden Signalkontakte 14 der Platine 1 entfernt. Das bedeutet, daß die Wandfläche 15 der trichterförmigen Enveiterung der Einlaufphase elektrisch isolierend ausgebildet ist. Diese elektrische Isolierung zwischen den jeweiligen Signalkontakten 14 der Platine und den Massekontakten 8 in Form der Leiteroberfläche 11 der Platine wird beim Einführen der wie bereits geschildert vorbereiteten Koaxialleitungen 2 in die Durchgangslöcher noch dadurch unterstützt, daß das elastische Dielektikum 9 sich an die Einlaufphase in Form einer trichterförmigen Erweiterung anschmiegt, indem sich die Isolierungen an die Wände der trichterförmigen Erweiterung anpressen, siehe dazu Figur 2. Auf diese Weise wird noch vor dem Einsetzen der Lötvorgänge verhindert, daß es beispielsweise durch flüssiges Lot zu Kurzschlüssen bei dem Anschließen der Signalleitungen und Masseleitungen kommen kann.

Wie aus Figur 3 ersichtlich ist, werden dann die Masseleitungen, beispielsweise in Form der Beidrähte, der Koaxialleitung 2 auf den Massekontakten 8 in Form der Leiteroberfläche 11 der Hochfrequenzsteckverbindungen angelötet, dies kann jedoch auch mit anderen elektrischen Verbindungsmethoden geschehen. Die Signalleitungen 5 der Koaxialleitungen 2 wurden so abgelängt, daß sie etwas über das Ende der Durchgangslöcher 3 hinausragen. Die Signalkontakte 14 der Platine 1 sind hier nur als Lötauge 16 zu sehen und werden mit Leiterbahnen zu den steckerseitigen Anschlüssen geführt, die jedoch hier nicht dargestellt sind. Aus dem geschilderten Anschlußvorgang von Signal- und Masseleitungen der Koaxialleitungen mit den Signal- und Massekontakten der Platine wird erkennbar, daß eine Trennung der elektrischen Anschlüsse der Signalleitungen und der Masseleitungen der einzelnen Koaxialleitungen in zwei elektrisch voneinander isolierte Ebenen erfolgt ist. Die Leiterplatine 1 wurde dazu beidseitig mit geeigneten Leiterbahnen versehen. Die Signalkontakte 14 der Platine 1 sind dabei im Abstand des hier nicht dargestellten Rastermaßes für Koaxialleitungen nebeneinander angeordnet. Auch hier werden die zahlreichen Koaxialleitungen im Abstand des vorgesehenen Rastermaßes auf einen Werkstückträger geklemmt und der Platine 1 gleichzeitig zugeführt. Positionierungsungenauigkeiten der Signalleitungen der Koaxialleitungen, die durch die Elastizität und die federnden Eigenschaften sowohl des Signalleiters wie auch der Isolierung hervorgerufen werden, können durch die trichterförmigen Erweiterungen der Einlaufphase 12 korrigiert werden. Es findet also eine Zwangsführung der Signalleitungen 5 der Koaxialleitungen 2 in die Durchgangslöcher 3 statt. Die um 90° abgebogenen Masseleitungen 10 der Koaxialleitungen 2 kommen dabei zwangsweise in Kontakt mit der Leiteroberfläche 11 der Platine 1. Es ist also sowohl die Potentialtrennung zwischen Signal- und Masseleitungen der Koaxialleitungen wie auch die Prozeßsicherheit für das Herstellen der elektrischen Verbindungen zwischen zusammengehörigen Kontakten bzw. Leitungen mit hoher Qualität gewährleistet. Das winkelige Abbiegen der Masseleitungen 10 der Koaxialleitungen 2 kann auch mit einem Winkel kleiner 90° erfolgen, da durch das Einführen der Koaxialleitungen in Zuführungsrichtung 4 in die Leiterplatine 1 bis zum Beginn der Abschirmungen 7 der Koaxialleitungen 2 ein entsprechendes Weiterbiegen der Masseleitungen der Koaxialleitungen automatisch bis zur Auflage erfolgt. Nach dem gleichzeitigen Einführen sämtlicher Koaxialleitungen in die Leiterplatine 1 können die elektrischen Verbindungen sowohl aller Masse- wie auch aller Signalanschlüsse der Koaxialleitungen und der Steckerplatine automatisch und gleichzeitig erfolgen. Es ist auch offenbar, daß die Durchgangslöcher in sehr engem Rasterabstand nebeneinander gesetzt werden können.

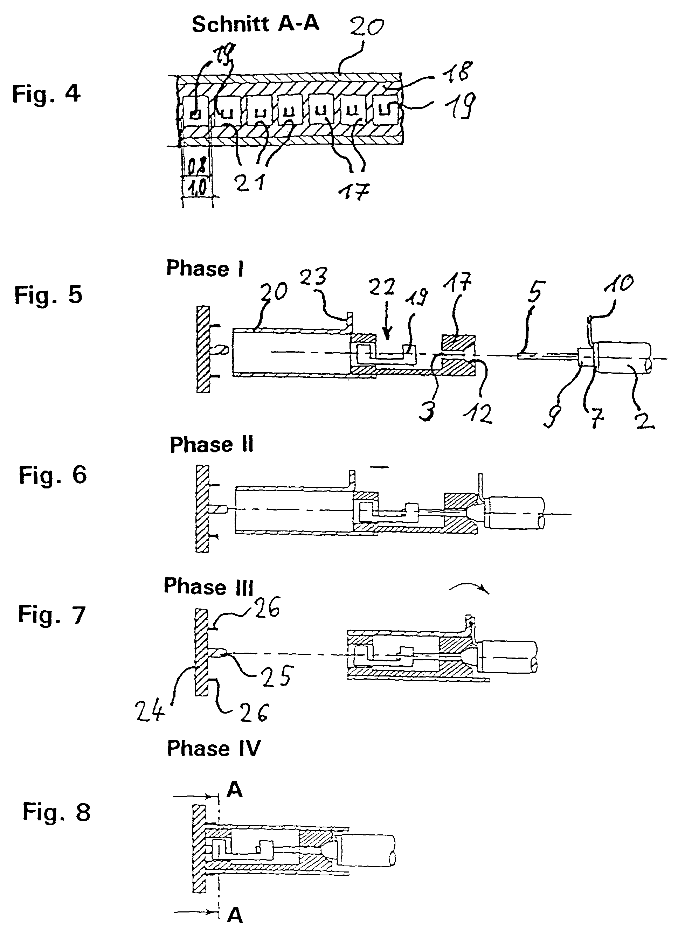

Ein zweites Ausführungsbeispiel der Erfindung in Form eines koaxialen Hochfrequenzsteckverbinders ist in den Figuren 4 bis 8 dargestellt und zwar in stark vergrößertem Maßstab. Die zahlreichen einzelnen Koaxialleitungen 2 werden in hier nicht dargestellter Weise beispielsweise von einem Werkstückträger in dem für den Stecker erforderlichen Rasterabstand gleichzeitig bereitgestellt. Die einzelnen Koaxialleitungen sind dabei in dem Werkstückträger starr fixiert. Dies ermöglicht auch eine Zuführung sowohl der Signalleitungen wie auch der Masseleitungen der einzelnen Koaxialleitungen in einem ganz bestimmten Winkel an Basisgehäuse 17 bzw. einem Zwischenträger 18 der Hochfrequenzsteckverbindungen. Der Einfachheit halber ist nur eine einzelne Koaxialleitung 2 dargestellt. In Wirklichkeit erfolgt der Anschluß für die zahlreichen nebeneinander zeilenartig angeordneten einzelnen Koaxialleitungen in die Basisgehäuse gleichzeitig. Die Koaxialleitungen 2 sind neben der Bereitstellung im Rasterabstand nebeneinander noch dadurch vorbereitet, daß die Signalleitungen 5 in der für die Signalkontakte 19 der Basisgehäuse 17 erforderlichen Länge abisoliert sind. Des weiteren sind auch die Masseleitungen 10 der Koaxialleitungen 2 bereits vormontiert. Diese Masseleitungen können aus der Abschirmung 7 der Koaxialleitungen 2 zusammengedreht sein. Bei der Verwendung von Koaxialleitungen mit einem oder zwei Massebeidrähten, wobei diese Massebeidrähte über die gesamte Länge der Koaxialleitungen mit dem Abschirmgeflecht verbunden sind, werden diese Massebeidrähte entsprechend abgeschnitten und in einen Winkel von 90° zur Signalleitung 5 abgebogen. Bei Verwendung von zwei Massebeidrähten genügt es, einen Massebeidraht abzuschneiden und den anderen zum Anschluß der Masse der Koaxialleitung an die koaxiale Hochfrequenzsteckverbindung zu verwenden. Das Dielektikum 9 zwischen der Signalleitung 5 und den Masseleitungen 10 der Koaxialleitungen 2, beispielsweise in Form einer Kunststoffisolierung, steht dabei soweit über die von der Koaxialleitung abgebogenen Masseleitungen hinaus, wie die Tiefe einer am Basisgehäuse 17 vorgesehene Einlaufphase 12 ausgebildet ist. Die Einlaufphase 12 ist eine trichterförmige Erweiterung des zentrisch angeordneten Durchgangsloches 3 des Basisgehäuses 17. Diese trichterförmigen Erweiterungen bei allen Basisgehäusen 17 sind den Durchgangslöchern 3 derart vorgelagert, daß alle Signalleitungen 5 der Koaxialleitungen 2 beim Heranführen an die Basisgehäuse 17 als erstes auf die trichterförmige Erweiterung der Einlaufphase 12 treffen. Dadurch wird es möglich auch dünne Drähte als Signalleitungen zu verwenden, die an sich federn bzw. auch durch die Isolierstoffe der Koaxialleitung leicht verbogen werden.

Der gemeinsame Zwischenträger 18 für die Basisgehäuse 17 ist zum Anschluß zahlreicher einzelner Koaxialleitungen vorgesehen, wobei deren Zahl nicht konstruktiv begrenzt ist, sondern lediglich den technischen Erfordernissen des jeweiligen Anwendungsfalles angepaßt werden muß, siehe dazu Figur 4. Der Zwischenträger 18 selbst ist aus einem nichtleitenden Material hergestellt, also beispielsweise aus Kunststoff. Dieser Zwischenträger wird von einem Gesamtgehäuse 20 vollständig umgeben. Das Gesamtgehäuse ist aus elektrisch leitendem Material hergestellt, so daß eine Hochfrequenzabschirmwirkung für alle in den Basisgehäusen des Zwischenträgers angeschlossenen Koaxialleitungen gegeben ist. Der Zwischenträger selbst ist als geschlossener zeilenartig fortgeführter Block ausgeführt und mit parallel nebeneinander liegenden und zu den einzuführenden Signalleitungen 5 hin geöffneten ersten Öffnungen 21 versehen. In diese Öffnungen sind die Basisgehäuse 17 zum Anschluß der einzelnen Koaxialleitungen 2 gleich integriert, d.h. die Basisgehäuse 17 sind zusammen mit dem Zwischenträger 18 einstückig hergestellt worden. Die Basisgehäuse 17 besitzen dabei alle einen zu den einzuführenden Signalleitungen hin gerichteten Signalkontakt 19, der zentrisch in dem Basisgehäuse angeordnet ist. Jedem einzelnen Signalkontakt 19 ist unmittelbar jeweils eine zweite Öffnung 22 in dem Zwischenträger 18 zugeordnet. Die zweite Öffnung 22 in unmittelbarer Nähe des Signalkontaktes 19 läßt die elektrische Verbindung der Signalkontakte 19 mit den Signalleitungen 5 der Koaxialleitungen 2 mittels Löten oder anderen geeigneten Verbindungsverfahren zu.

Durch die Einführung des Kombinationsmerkmales der Einlaufphase in Form einer trichterförmigen Erweiterung werden bei dem Anschließen, d.h. der Zuführung der Signalleitungen 5 in die Basisgehäuse 17, sämtliche auch leicht versetzte Signalleitungen 5 in den Toleranzbereich der Einlaufphase 12 gebracht und dadurch die Signalleitungen 5 sicher in die Durchgangslöcher 3 der Basisgehäuse 17 eingeführt. Somit kann eine Kontaktierung der Signalleitungen 5 mit dem Signalkontakt 19 der Basisgehäuse 17 sicher erfolgen, siehe dazu Figur 6. Das über die abgebogenen Masseleitungen 10 der Koaxialleitungen 2 hinausstehende Dielektikum 9 in Form einer Kunststoffisolierung ist elastisch ausgebildet. Diese Kunststoffisolierung wird beim Einführung der Koaxialleitungen 2 in die Basisgehäuse 17 in die trichterförmige Erweiterung der Einlaufphase 12 gepreßt. Dadurch wird die elastische Isolierung entsprechend der Form der trichterförmigen Erweiterung der Einlaufphase 12 verformt und liegt unter Druck und dicht an den Wänden dieser trichterförmigen Erweiterung an. Nachdem dies geschehen ist, können also die Mittelleiter bzw. die Signalleitungen 5 der Koaxialleitungen 2 mit den Signalkontakten 19 der Basisgehäuse 17 elektrisch verbunden werden. Dabei kann jedes dafür geeignete Verfahren aus dem Stand der Technik Anwendung finden.

Das Gesamtgehäuse 20 für den Zwischenträger 18 verfügt über eine der Gesamtzahl der anzuschließenden einzelnen Koaxialleitungen 2 entsprechende Anzahl von Massekontakten 23, die in Form verbiegbarer an der Gesamtgehäusewand angeordneter Laschen ausgeführt sind. Die Laschen können dabei als Teil der Gesamtgehäusewand ausgebildet sein. Die Massekontakte 23 in Form verbiegbarer Laschen des Gesamtgehäuses wie auch die Masseleitungen 10 der Koaxialleitungen 2 werden jeweils winkelig abgebogen, vorteilhafterweise in einem Winkel von 90°.

Der Zwischenträger 18 ist verschiebbar in dem Gesamtgehäuse 20 gelagert. Nachdem die Signalleitungen 5 mit den Signalkontakten 19 der Basisgehäuse 17 alle und automatisch sowie maschinell verbunden sind, werden sie, da die Basisgehäuse in den Zwischenträger 18 einstückig integriert sind, automatisch sowie maschinell in das Gesamtgehäuse 20 eingeschoben, siehe dazu Figur 7. Wenn der Zwischenträger 18 ganz in das Gesamtgehäuse 20 eingeschoben ist, so liegen die um 90°von der Koaxialleitung 2 abgebogenen Masseleitungen 10 und die ebenfalls um 90° von der Gesamtgehäusewand abgebogenen Massekontakte 23 des Gesamtgehäuses 20 planparallel aufeinander. Jetzt werden die Massekontakte 23 und Masseleitungen 10 elektrisch durch Löten, Schweißen oder in jeder anderen geeigneten Form verbunden.

In einem letzten Schritt werden die elektrisch verbundenen Massekontakte 23 des Gesamtgehäuses 20 und die Masseleitungen 10 aller Koaxialleitungen 2 maschinell wieder in die Ebene der Gesamtgehäusewand zurückgebogen. Der erfindungsgemäße koaxiale Hochfrequenzsteckverbinder kann wahlweise mit einem Buchsenstecker 24 verbunden werden, wie es in den Figuren 4 bis 8 insbesondere aber in Figur 8, dargestellt ist. Der Buchsenstecker 24 hat wiederum einen Signalkontakt 25 und Massekontakte 26. Der erfindungsgemäße koaxiale Hochfrequenzsteckverbinder kann auch mit einem entsprechenden Stiftstecker verbunden werden, der jedoch hier nicht dargestellt ist. Der Masseabgriff der Masseleitungen aller einzelnen Koaxialleitungen erfolgt dabei über das Gesamtgehäuse 20.

### Bezugszeichenliste

- 1.: Leiterplatine
- 2.: Koaxialleitungen
- 3.: Durchgangslöcher
- 4.: Zuführungsrichtungen der Koaxialleitungen
- 5.: Signalleitungen
- 6.: Mantel
- 7.: Abschrimung
- 8.: Massekontakte der Steckverbindung
- 9.: Dielektrikum
- 10.: Masseleitungen
- 11.: Leiteroberfläche
- 12.: Einlaufphasen
- 13.: der Zuführungsrichtung der Koaxialleitungen abgewandte Seite der Platine
- 14.: Signalkontakte der Platine
- 15.: Wandfläche der trichterförmigen Erweiterung
- 16.: Lötauge
- 17.: Basisgehäuse
- 18.: Zwischenträger
- 19.: Signalkontakt im Basisgehäuse
- 20.: Gesamtgehäuse
- 21.: Erste Öffnung
- 22.: Zweite Öffnung
- 23.: Massekontakte des Gesamtgehäuses
- 24.: Buchsenstecker
- 25.: Signalkontakt des Buchsensteckers
- 26.: Massekontakt des Buchsensteckers

## Patentansprüche

1. Anordnung zur Verbindung von Signal- und Masseleitungen aufweisenden Koaxialleitungen mit elektrischen Signal- und Masseanschlußelementen einer Anschlußvorrichtung,
wobei die Anschlußelemente für die Signal- und Masseleitungen der einzelnen Koaxialleitungen jeweils nebeneinander zu liegen kommen und mit den zugehörigen Anschlußelementen elektrisch verbunden sind und wobei die Signalanschlußelemente mittels einer Isoliereinrichtung gegeneinander elektrisch isoliert sind,
dadurch gekennzeichnet,
daß die Masseanschlußelemente (11; 23) für die Masseleitungen (10) auf einer zu den Koaxialleitungen (2) weisenden Seite der Isoliereinrichtung (1; 17) und die Signalanschlußelemente (14; 19) für die Signalleitungen (5) auf einer von den Koaxialleitungen (2) wegweisenden Seite der Isoliereinrichtung (1; 17) angeordnet sind,
daß für die Signalleitungen (5) der Koaxialleitungen (2) Durchgangslöcher (3) durch die Isoliereinrichtung (1; 17) im Abstand des Rastermaßes für die Koaxialleitungen (2) nebeneinander vorgesehen sind,
daß den Durchgangslöchern (3) für die Signalleitungen (5) je eine sich in Richtung zu den Koaxialleitungen (2) erweiternde trichterförmige Erweiterung (12) vorgelagert ist,
daß die Wandflächen der trichterförmigen Erweiterungen (12) elektrisch isolierend ausgebildet sind
und daß die Masseleitungen (10) der Koaxialleitungen (2) winkelig von den Signalleitungen (5) abgebogen sind.

2. Anordnung nach Anspruch 1,
dadurch gekennzeichnet,
daß die Isoliereinrichtung durch eine Leiterplatine (1) gebildet ist und daß die Signalanschlußelemente durch Signalleiterbahnen (14) auf einer Seite der Leiterplatine (1) und die Masseanschlußelemente durch mindestens einen Massekontakt (11) auf der anderen Seite der Leiterplatine (1) gebildet sind.

3. Anordnung nach Anspruch 1,
dadurch gekennzeichnet,
daß die Isoliereinrichtung durch eine Mehrzahl in einem Zwischenträger (18) angeordneter Basisgehäuse (17) gebildet ist,
daß die Signalanschlußelemente durch Signalkontakte (19) gebildet sind, die auf einer von den Koaxialleitungen (2) wegweisenden Stelle der Basisgehäuse (17) angeordnet sind,
daß der Zwischenträger in einem Gesamtgehäuse (20) aus elektrisch leitendem Material untergebracht ist,
daß die Masseanschlußelemente durch an dem Gesamtgehäuse (20) angeordnete Laschen (23) gebildet sind
und daß sowohl die Laschen (23) als auch die Masseleitungen (10) der Koaxialleitungen (2) zu deren elektrischer Verbindung winkelig von den Signalleitern (5) der Koaxialleitungen (2) bzw. dem Gesamtgehäuse (20) abgebogen sind.

4. Anordnung nach einem der Ansprüche 1 bis 3,
dadurch gekennzeichnet,
daß der Abbiegewinkel der Masseleitungen (10) von den Koaxialleitungen (2) jeweils kleiner oder gleich 90° ausgebildet ist.

5. Anordnung nach Anspruch 2 oder 4,
dadurch gekennzeichnet,
daß die Massekontakte (8) als gemeinsame Leiteroberfläche (11) der Leiterplatine (1) ausgebildet sind.

6. Anordnung nach Anspruch 3 oder 4,
dadurch gekennzeichnet,
daß sämtliche Masseleitungen (10) der Koaxialleitungen (2) bei mit den Signalkontakten (19) der Basisgehäuse (17) bereits verbundenen Signalleitungen (5) nach Einschub des Zwischenträgers (18) in das Gesamtgehäuse (20) parallel an den Massekontakten (22) des Gesamtgehäuses (20) anliegen.

7. Anordnung nach einem der Ansprüche 3, 4 oder 6,
dadurch gekennzeichnet,
daß die Laschen als Teil der Gesamtgehäusewand ausgebildet sind.

8. Anordnung nach einem der Ansprüche 3, 4, 6 oder 7
dadurch gekennzeichnet,
daß der Abbiegewinkel der Masseleitungen (10) von den Koaxialleitungen (2) und der Massekontakte (23) in Form der Masselaschen der Gesamtgehäusewand jeweils 90° beträgt.

9. Steckverbinder für den Anschluß mehrerer Koaxialleitungen (2),
dadurch gekennzeichnet,
daß eine Anordnung nach einem der Ansprüche 2, 4 oder 5 in einem Verbindergehäuse untergebracht ist
und daß an dem Verbindergehäuse oder an der Leiterplatine (1) angeordnete Steckverbindungsvorrichtungen über die Signalleitungen (14) und die Masseleitungen (11) der Leiterplatine (1) mit den Signalleitungen (5) bzw. Masseleitungen (10) der Koaxialleitungen verbindbar sind.

10. Steckverbinder für den Anschluß mehrerer Koaxialleitungen (2),
dadurch gekennzeichnet,
daß bei einer Anordnung nach einem der Ansprüche 3, 4, 6, 7 oder 8 die Signalkontakte (19) und das Gesamtgehäuse (20) auf ihren von den Koaxialleitungen abliegenden Seiten mit Steckverbindungselementen versehen sind.

## Claims

1. An arrangement for connecting coaxial lines including signal and ground lines to electrical signal and ground terminating members of a connecting device,
with the terminating members for the signal and ground lines of the individual coaxial lines each coming to lie beside each other and being electrically connected to the associated terminating members, and with the signal terminating members being electrically insulated from each other by an insulating means (1),
characterized in that the ground terminating members (11; 23) for the ground lines (10) are disposed on a side of the insulating means (1; 17) facing towards the coaxial lines (2) and the signal terminating members (14; 19) for the signal lines (5) are disposed on a side of the insulating means (1; 17) facing away from the coaxial lines (2),
that through-holes (3) for the signal lines (5) of the coaxial lines (2) are provided through the insulating means (1; 17) beside each other with the spacing of the grid distance for the coaxial lines (2),
that the through-holes (3) for the signal lines (5) each have a funnel-shaped expansion (12) disposed in front thereof, which expands in the direction towards the coaxial lines (2),
that the wall surfaces of the funnel-shaped expansions (12) are formed to be electrically insulating,
and in that the ground lines (10) of the coaxial lines (2) are bent from the signal lines (5) in angular manner.

2. The arrangement of claim 1,
characterized in that the insulating means is constituted by a printed circuit board (1),
and in that the signal terminating members are constituted by signal conductors (14) on one side of printed circuit board (1) and the ground terminating members are constituted by at least one ground contact (11) on the other side of printed circuit board (1).

3. The arrangement of claim 1,
characterized in that the insulating means is constituted by a plurality of base housings (17) disposed in an intermediate support (18),
that the signal terminating members are constituted by signal contacts (19) disposed at a location of said base housing (17) facing away from the coaxial lines (2),
that said intermediate support in accommodated in an overall housing (20) of electrically conducting material,
that said ground terminating members are constituted by lugs (23) disposed on the overall housing (20),
and in that both the lugs (23) and the ground lines (10) of the coaxial lines (2), for electrical connection thereof, are bent in angular manner from the lines (5) of the coaxial lines (2) and from the overall housing (20), respectively.

4. The arrangement of any of claims 1 to 3,
characterized in that the bending angle of the ground lines (10) from the coaxial lines (2) is smaller than or equal to 90° each.

5. The arrangement of claim 2 or 4,
characterized in that the ground contacts (8) are formed as common conductor surface (11) of the printed circuit board (1).

6. The arrangement of claim 3 or 4,
characterized in that all ground lines (10) of the coaxial lines (2), when signal lines (5) are already connected to the signal contacts (19) of the base housings (17), abut the ground contacts (22) of the overall housing (20) in parallel manner upon insertion of the intermediate support (18) into the overall housing (20).

7. The arrangement of any of claims 3, 4 or 6,
characterized in that the lugs are formed as part of the overall housing wall.

8. The arrangement of any of claims 3, 4, 6 or 7,
characterized in that the bending angle of the ground lines (10) from the coaxial lines (2) and of the ground contacts (23) in form of the ground lugs of the overall housing wall is 90° each.

9. A plug-type connector for termination of a plurality of coaxial lines (2),
characterized in that an arrangement according to any of claims 2, 4 or 5 is accommodated in a connector housing,
and in that pluggable connecting devices disposed on the connector housing or on the printed circuit board (1) are adapted to be connected to the signal lines (5) and ground lines (10) of the coaxial lines via the signal lines (14) and the ground lines (11), respectively, of the printed circuit board (1).

10. A plug-type connector for termination of a plurality of coaxial lines (2),
characterized in that, in an arrangement according to any of claims 3, 4, 6, 7 or 8, the signal contacts (19) and the overall housing (20) are provided with pluggable connecting members on their sides facing away from the coaxial lines.

## Revendications

1. Disposition pour la connexion de lignes coaxiales présentant des lignes de signaux et des conducteurs à la masse, avec des éléments électriques de connexion de signaux et de connexion à la masse d'un dispositif de connexion,
où les éléments de connexion pour les lignes de signaux et les conducteurs à la masse des différentes lignes coaxiales sont à disposer respectivement les uns à côté des autres et sont connectés électriquement avec les éléments de connexion afférents et où les éléments de connexion des signaux sont isolés électriquement les uns des autres au moyen d'un dispositif isolant,
caractérisé
- en ce que les éléments (11 ; 23) de connexion à la masse pour les conducteurs (10) à la masse sont disposés sur un côté du dispositif isolant (1 ; 17) se présentant vers les lignes coaxiales (2) et en ce que les éléments (14 ; 19) de connexion des signaux pour les lignes (5) de signaux sont disposés sur un côté du dispositif isolant (1 ; 17) se trouvant à l'opposé des lignes coaxiales (2),
- en ce que, pour les lignes (5) de signaux des lignes coaxiales (2), des trous (3) de passage à travers le dispositif isolant (1 ; 17) sont prévus pour les lignes coaxiales (2), en étant placés l'un à côté de l'autre suivant l'espacement du gabarit de trame,
- en ce qu'un élargissement (12) s'évasant en direction des lignes coaxiales (2) est placé à chaque fois en amont des trous (3) de passage pour les lignes (5) de signaux,
- en ce que les surfaces des parois des élargissements (12) en forme d'entonnoir sont constituées en étant électriquement isolantes, et
- en ce que les conducteurs (10) à la masse des lignes coaxiales (2) sont recourbés de façon angulaire par rapport aux lignes (5) de signaux.

2. Disposition selon la revendication 1, caractérisée
- en ce que le dispositif isolant est constitué par une carte (1) de circuits imprimés, et
- en ce que les éléments de connexion des signaux sont constitués par des pistes conductrices (14) de signaux sur un côté de la carte (1) de circuits imprimés, et
- en ce que les éléments de connexion à la masse sont constitués au moins par un contact (11) à la masse de l'autre côté de la carte (1) de circuits imprimés.

3. Disposition selon la revendication 1, caractérisée
- en ce que le dispositif isolant est constitué par plusieurs boîtiers de base (17) disposés dans un support intermédiaire (18),
- en ce que les éléments de connexion de signaux sont constitués par des contacts (19) de signaux qui sont disposés sur un emplacement des boîtiers de base (17), placé à l'opposé des lignes coaxiales (2),
- en ce que le support intermédiaire est logé dans un boîtier d'ensemble (20) fabriqué dans un matériau électriquement conducteur,
- en ce que les éléments de connexion à la masse sont constitués par des languettes (23) disposées sur le boîtier d'ensemble (20), et
- en ce que aussi bien les languettes (23) que les conducteurs (10) à la masse des lignes coaxiales (2), pour leur connexion électrique, sont recourbés de façon angulaire par rapport aux lignes (5) de signaux des lignes coaxiales (2) ou par rapport au boîtier d'ensemble (20).

4. Disposition selon l'une quelconque des revendications 1 à 3, caractérisée en ce que l'angle de courbure des conducteurs (10) à la masse des lignes coaxiales (2) est à chaque fois inférieur ou égal à 90°.

5. Disposition selon la revendication 2 ou 4, caractérisée en ce que les contacts (8) à la masse sont configurés comme une surface conductrice commune (11) de la carte (1) de circuits imprimés.

6. Disposition selon la revendication 3 ou 4, caractérisée en ce que tous les conducteurs (10) à la masse des lignes coaxiales (2), dans le cas de lignes (5) de signaux déjà reliées à des contacts (19) de signaux des boîtiers de base (17), s'appliquent de façon parallèle sur les contacts (22) à la masse du boîtier d'ensemble (20) après insertion du support intermédiaire (18) dans le boîtier d'ensemble (20).

7. Disposition selon l'une quelconque des revendications 3, 4 ou 6, caractérisée en ce que les languettes sont configurées comme une partie de la paroi du boîtier d'ensemble.

8. Disposition selon l'une quelconque des revendications 3, 4, 6 ou 7, caractérisée en ce que l'angle de courbure des conducteurs (10) à la masse, par rapport aux lignes coaxiales (2), et des contacts (23) à la masse sous forme de languettes, à la masse, de la paroi du boîtier d'ensemble, est à chaque fois de 90°.

9. Connecteur mâle-femelle pour la connexion de plusieurs lignes coaxiales (2), caractérisé
- en ce qu'une disposition selon l'une quelconque des revendications 2, 4 ou 5 est logée dans un boîtier de connecteur, et
- en ce que des dispositifs de connexion enfichables, disposés sur le boîtier du connecteur ou sur la carte (1) de circuits imprimés, peuvent être connectés aux lignes (5) de signaux ou aux conducteurs (10) à la masse des lignes coaxiales, via les lignes (14) de signaux et les conducteurs (11) à la masse de la carte (1) de circuits imprimés.

10. Connecteur mâle-femelle pour la connexion de plusieurs lignes coaxiales (2), caractérisé en ce que, dans le cas d'une disposition selon l'une quelconque des revendications 3, 4, 6, 7 ou 8, les contacts (19) de signaux et le boîtier d'ensemble (20) sont dotés, sur leurs côtés placés à l'opposé des lignes coaxiales, d'éléments de connexion enfichable.
